(19) Europäisches Patentamt / European Patent Office / Office européen des brevets

(11) **EP 2 828 968 B1**

(12) **FASCICULE DE BREVET EUROPEEN**

(45) Date de publication et mention de la délivrance du brevet:
**30.12.2015 Bulletin 2015/53**

(21) Numéro de dépôt: **13719910.5**

(22) Date de dépôt: **22.03.2013**

(51) Int Cl.:
***H02N 2/00*** *(2006.01)*

(86) Numéro de dépôt international:
**PCT/FR2013/050622**

(87) Numéro de publication internationale:
**WO 2013/140102 (26.09.2013 Gazette 2013/39)**

(54) **DISPOSITIF DE MICROPOSITIONNEMENT A MULTI DEGRES DE LIBERTE POUR ACTIONNEURS PIEZOELECTRIQUES ET PROCEDE ASSOCIE**

MIKROPOSITIONIERUNGSVORRICHTUNG MIT MEHREREN FREIHEITSGRADEN FÜR PIEZOELEKTRISCHE AKTUATOREN UND ZUGEHÖRIGE VERFAHREN

MICROPOSITIONING DEVICE WITH MULTIDEGREES OF FREEDOM FOR PIEZOELECTRIC ACTUATORS AND ASSOCIATED METHOD

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **22.03.2012 FR 1252554**

(43) Date de publication de la demande:
**28.01.2015 Bulletin 2015/05**

(73) Titulaires:
• **Université de Franche-Comté**
  **25000 Besançon (FR)**
• **Ecole Nationale Superieure de Mecanique et Des Microtechniques**
  **25000 Besancon (FR)**

(72) Inventeurs:
• **IVAN, Ioan Alexandru**
  **F-42023 Saint-Etienne (FR)**
• **AGNUS, Joël**
  **F-25870 Auxon-Dessous (FR)**
• **RAKOTONDRABE, Manitrarivo**
  **F-25000 Besancon (FR)**

(74) Mandataire: **Novagraaf Technologies**
  **Bâtiment O2**
  **2, rue Sarah Bernhardt**
  **CS90017**
  **92665 Asnières-sur-Seine Cedex (FR)**

(56) Documents cités:
EP-A2- 0 375 570    US-A- 4 945 235
US-A- 5 675 296     US-B1- 6 285 115

**Description**

**DOMAINE TECHNIQUE DE L'INVENTION**

Le domaine technique de l'invention est celui des méthodes de positionnement d'actionneurs, notamment piézoélectriques et a plus particulièrement pour objet un procédé de micropositionnement pour actionneurs piézoélectriques et un dispositif associé.

**ETAT DE LA TECHNIQUE ANTERIEURE**

La problématique du micropositionnement pour actionneurs piézoélectriques a suscité déjà plusieurs solutions, en particulier celle consistant à commander en tension un actionneur comprenant une paire d'électrodes de sorte à déformer un matériau piézoélectrique disposé entre la paire d'électrode.

Généralement, ce type de dispositifs prévoit des moyens de mesure de la déformation dont des capteurs sont situés au niveau du matériau piézoélectrique (jauges extensiométriques), ou des moyens de mesure du déplacement de la structure commandée dont des capteurs sont situés à l'extérieur de ladite structure (capteurs optiques par triangulation ou interférométrique).

Néanmoins, ces capteurs extensiométriques présentent un rapport signal sur bruit défavorables tandis que les capteurs externes sont très encombrants, d'autant plus que ces dispositifs doivent comporter autant de capteurs que de degrés de liberté sur lesquels une mesure doit être effectuée. L'utilisation de tels dispositifs est donc limitée à des applications dont l'espace de confinement des moyens de mesure n'est pas une problématique. Par ailleurs, ces dispositifs, très précis, sont très coûteux, le prix étant d'autant plus élevé que le nombre de degrés de liberté est important. Des dispositifs de l'art antérieur sont décrits par US 6 285 115 B1, US 4 945 235, US 5 675 296 et EP 0 375 570.

**EXPOSE DE L'INVENTION**

L'invention vise à remédier à tout ou partie des inconvénients de l'état de la technique, en particulier aux problèmes posés par l'encombrement et le prix des moyens de mesure des déplacements de structures actionnées par au moins un actionneur piézoélectrique actionneur piézoélectrique commandé en tension.

Selon un premier aspect de l'invention, un dispositif de micropositionnement d'au moins un actionneur piézoélectrique, ledit actionneur piézoélectrique comprenant au moins un matériau piézoélectrique lequel est apte à se déformer lorsqu'il est soumis à un champ électrique, caractérisé en ce qu'il comprend en outre :

- des moyens de commande d'un champ électrique appliqué audit actionneur piézoélectrique de sorte à déformer le matériau piézoélectrique et,

- des moyens de mesure simultanée d'une variation de charge électrique accumulée sur l'actionneur piézoélectrique résultant de la déformation; et

- des moyens d'acquisition des mesures de la variation de charge électrique, de traitement de ces acquisitions et d'estimation d'un déplacement de l'actionneur piézoélectrique et/ou d'une force appliquée à partir de la mesure de la variation de charge électrique accumulée sur l'actionneur piézoélectrique,

tel que les moyens de commande et de mesure comprennent en outre :

- un générateur de tension connecté en parallèle à :

  • un pont diviseur, le pont diviseur étant composé d'une première résistance et d'une seconde résistance en série, et à
  • une première capacité connectée en série à l'actionneur piézo-électrique,

- un amplificateur de charges ayant une première entrée connectée à un noeud entre les deux résistances formant une masse virtuelle à haut potentiel flottant et une seconde entrée connectée à un noeud entre la première capacité et l'actionneur piézo-électrique.

Ce dispositif s'affranchit de capteurs extérieurs en ce qu'il permet d'exploiter à la fois le même matériau piézoélectrique comme actionneur et comme son propre capteur.

En d'autres termes, il est possible de s'affranchir d'une mesure de la déformation réelle du matériau piézoélectrique et/ou du déplacement de l'actionneur et/ou de la force appliquée par une mesure de la variation de la charge électrique réelle présente sur l'actionneur piézoélectrique et par calcul (algorithme d'estimation) à partir de cette mesure de variation de la charge électrique réelle.

Bien que ce dispositif puisse sembler impliquer une erreur plus importante sur la précision des mesures obtenues en comparaison de l'art antérieur, il s'avère de manière surprenante que la qualité de la mesure de position d'un tel actionneur est très satisfaisante, i.e. de l'ordre de quelques nanomètres RMS (« Root Mean Square, c'est-à-dire ici la moyenne quadratique), soit meilleure qu'un capteur optique par triangulation et sensiblement comparable à une mesure interférométrique.

D'autre part, le fait de s'affranchir de capteur de mesure permet l'économie de l'achat desdits capteur soit de diminuer considérablement le coût du dispositif.

Un tel dispositif permet en outre de pouvoir effectuer des mesures simultanées de la déformation matériau piézoélectrique selon une pluralité de degrés de liberté, et ce sur des dispositifs dont le dimensionnement est une problématique. L'encombrement est donc minimal. Par ailleurs, un tel dispositif permet un pilotage « temps réel » du dispositif de micropositionnement associé.

Le dispositif s'affranchit également de capteurs extérieurs en ce qu'il permet d'exploiter à la fois le même matériau piézoélectrique comme actionneur et comme son propre capteur.

En d'autres termes, il est possible de s'affranchir d'une mesure de la déformation réelle du matériau piézoélectrique et/ou du déplacement de l'actionneur et/ou de la force appliquée par une mesure de la variation de la charge électrique réelle présente sur l'actionneur piézoélectrique et par calcul algorithmique à partir de cette mesure de la variation de la charge électrique réelle.

Il est à noter que les moyens d'estimation peuvent permettre d'estimer, en sus d'un déplacement de l'actionneur piézoélectrique et/ou d'une force appliquée par un environnement extérieur sur ledit actionneur piézoélectrique, tout autre paramètre dépendant directement ou indirectement de ladite variation de charge électrique mesurée par les moyens de mesure.

Selon une caractéristique particulière, l'actionneur piézoélectrique comprend au moins trois électrodes réparties dont au moins une électrode de masse et au moins deux électrodes de potentiels actifs. Par exemple, l'actionneur piézoélectrique peut être un piézotube ou tout autre actionneur à plusieurs degrés de liberté. Dans le cas d'un actionneur piézoélectrique de type piézotube, ledit piézotube comprend le matériau piézoélectrique formant tube, l'électrode de masse disposée sur une paroi interne du tube et au moins deux électrodes de potentiels actifs disposées sur une paroi externe du tube.

Le nombre d'électrodes extérieures varie de préférence en fonction du nombre de degrés de libertés sur lesquels une mesure doit être effectuée. Ainsi, dans le cas où sont utilisées au moins deux électrodes de potentiels actifs, il est possible de commander l'actionneur piézoélectrique selon respectivement au moins deux degrés de liberté.

Avantageusement, les moyens de commande du champ électrique et de mesure simultanée de la variation de la charge électrique comportent au moins un circuit de commande du champ électrique appliqué audit actionneur piézoélectrique et de mesure de la variation de charge accumulée sur les électrodes de potentiels actifs.

Avantageusement, l'amplificateur de charges comprend un amplificateur opérationnel et une seconde capacité connectée entre la seconde entrée et la sortie de l'amplificateur opérationnel.

Selon une autre caractéristique, les moyens de commande et de mesure comprennent en outre un circuit de remise à zéro des charges présentes sur le second condensateur.

Le dispositif piézo-électrique étant assimilable au repos à une capacité, la première capacité et les première et seconde résistances sont choisies de sorte que le ratio entre la première et la seconde résistance est sensiblement égal au ratio entre la première capacité et la capacité du dispositif piézo-électrique au repos.

Avantageusement, la première capacité est sélectionnée pour avoir une résistance de fuite supérieure à 100 GOhm.

Par ailleurs, la première capacité est sélectionnée de sorte à ce que la majeure partie de la tension délivrée par le générateur de tension se retrouve sur le dispositif piézo-électrique, étant entendu par le vocable «majeure partie » de la tension, au moins supérieur à 50% de cette tension. De préférence, la première capacité est sélectionnée de sorte à ce que 90% de la tension délivrée par le générateur de tension se retrouve sur le dispositif piézo-électrique.

Dans une autre configuration avantageuse, la sortie de chaque amplificateur de charges est connectée à un convertisseur analogique-numérique connecté à un calculateur via des circuits d'isolation galvanique ; le calculateur estimant le déplacement de l'actionneur et/ou la déformation du matériau et/ou la force appliquée à partir de la variation de charges reçue des amplificateurs de charges et des tensions appliquées par les générateurs de tension. Réciproquement, dans un autre mode de réalisation, l'isolation galvanique peut être réalisée en analogique, dans ce cas le convertisseur analogique-numérique est disposé après les circuits d'isolation galvanique.

Avantageusement, le dispositif piézo-électrique comporte au moins trois électrodes dont au moins une électrode de masse et au moins deux électrodes de potentiels actifs, le dispositif comprenant autant de moyens de commande et de mesure que d'électrodes actives, connectés un à un, et les moyens de commande et de mesure étant connectés à un unique calculateur adapté pour déplacer et mesurer le dispositif piézo-électrique dans au moins deux dimensions.

Selon un second aspect, l'invention concerne un procédé de micropositionnement d'au moins un actionneur piézoélectrique mis en oeuvre par un dispositif comme décrit ci-dessus, caractérisé en ce qu'il comprend les étapes suivantes :

- des étapes:

    - de commande de l'actionneur piézoélectrique par application d'un champ électrique audit actionneur piézoélectrique de sorte à déformer le matériau piézoélectrique ; et

    - de mesure simultanée d'une variation de charge électrique accumulée sur l'actionneur piézoélectrique résultant de la déformation ;

- au moins une étape d'acquisition des mesures de la variation de charge électrique, de traitement de ces acquisitions et d'estimation d'un déplacement de l'actionneur piézoélectrique et/ou de la force appliquée à partir de la mesure de la variation de charge électrique accumulée sur l'actionneur piézoélectrique.

## BREVE DESCRIPTION DES FIGURES

D'autres caractéristiques, détails et avantages de l'invention ressortiront à la lecture de la description qui suit, en référence aux figures annexées, où :

- la figure 1 montre un schéma fonctionnel des moyens de commande, de mesure simultanée et des moyens d'acquisition, de traitement et d'estimation selon un mode de réalisation ;

- la figure 2 montre un schéma de principe d'un actionneur selon ce mode de réalisation ;

- la figure 3 montre un schéma structurel général d'un dispositif de micropositionnement d'un actionneur piézoélectrique selon ce mode de réalisation ;

- les figures 4a et 4b montrent des schémas d'un circuit électrique associé à une électrode selon ce mode de réalisation ;

- la figure 5 montre un schéma d'un circuit électrique d'ensemble associé à un actionneur piézoélectrique de type piézotube selon ce mode de réalisation

- la figure 6 montre un schéma bloc détaillé d'un observateur, ou estimateur, selon ce mode de réalisation ;

Pour plus de clarté, les éléments identiques ou similaires des différents modes de réalisation seront repérés par des signes de référence identiques sur l'ensemble des figures. Leur description ne sera pas systématiquement répétée d'un mode de réalisation à l'autre.

## DESCRIPTION DETAILLEE D'UN MODE DE REALISATION

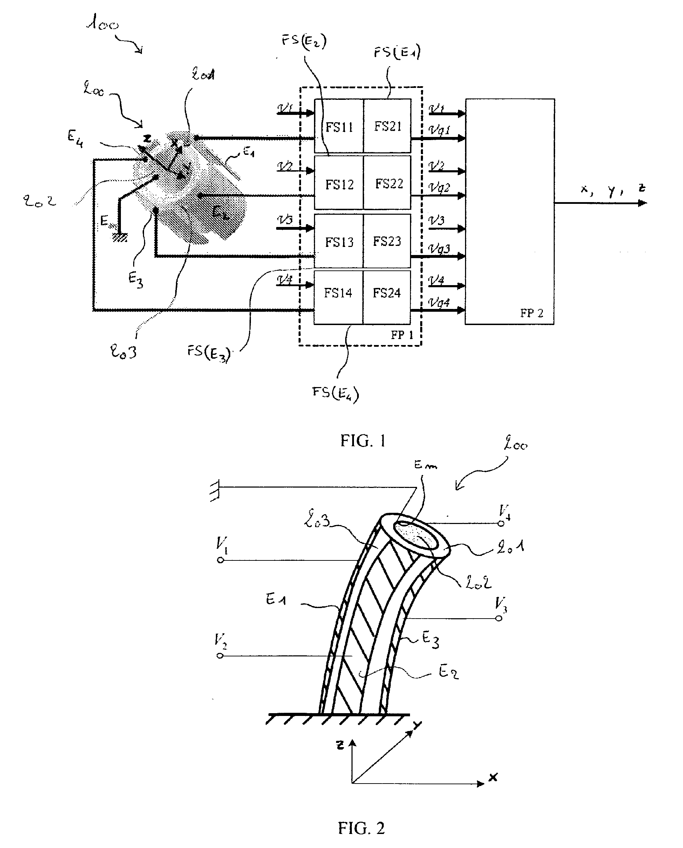

La figure 1 montre un schéma fonctionnel des moyens de commande, de mesure simultanée et des moyens d'acquisition, de traitement et d'acquisition selon un mode de réalisation.

Est plus précisément représenté sur cette figure, un dispositif de micropositionnement 100 d'un actionneur piézoélectrique 200, ledit actionneur piézoélectrique 200 comprenant un matériau piézoélectrique 201 apte à se déformer lorsqu'il est soumis à un champ électrique.

Dans ce mode de réalisation l'actionneur piézoélectrique 200 est un piézotube comprenant le matériau piézoélectrique 201 formant tube, une électrode de masse $E_m$ disposée sur une paroi interne 202 du tube et quatre électrodes $E_1$, $E_2$, $E_3$, $E_4$ de potentiels actifs disposées sur différents secteurs d'une paroi externe 203 du tube.

Le piézotube est ici défini dans un référentiel orthogonal d'axes x, y et z, l'axe z étant l'axe longitudinal de la forme tubulaire dudit piézotube.

Dans une telle configuration, l'application d'une tension sur ces électrodes de potentiels actifs $E_1$, $E_2$, $E_3$, $E_4$, donc d'un champ électrique, permet d'imposer une déformation longitudinale des différents secteurs du matériau piézoélectrique 201 formant tube conduisant à une déflexion selon les axes x et y ainsi qu'une contraction ou élongation selon l'axe z.

Plus précisément, le dispositif de micropositionnement 100 présente ici deux fonctions principales :

- une première fonction principale FP1, permettant la commande et la mesure simultanée d'une variation de la charge sur les différents secteurs du piézotube ; et

- une seconde fonction principale FP2, assurant l'acquisition, le traitement et l'estimation des déplacements x, y et z.

Par ailleurs, la fonction principale FP1 est subdivisée en quatre fonctions secondaires $FS(E_1)$, $FS(E_2)$, $FS(E_3)$, $FS(E_4)$, chacune associée à une électrode de potentiel actif $E_1$, $E_2$, $E_3$, $E_4$.

En outre, en, chacune des fonctions secondaires $FS(E_1)$, $FS(E_2)$, $FS(E_3)$, $FS(E_4)$ est subdivisée en deux fonctions secondaires par électrode de potentiel actif $E_1$, $E_2$, $E_3$, $E_4$. Ainsi, chacune des quatre électrodes de potentiel actif $E_1$, $E_2$, $E_3$, $E_4$ assure respectivement :

- une première fonction secondaire FS11, FS12, FS13, FS14 assurée par des moyens de commande d'un champ électrique appliqué audit actionneur piézoélectrique 200 de sorte à déformer le matériau piézoélectrique, cette première fonction assurant ladite commande du champ électrique audit actionneur piézoélectrique (200) ; et

- une deuxième fonction secondaire FS21, FS22, FS23, FS24 assurée par des moyens de mesure simultanée d'une variation de charge électrique accumulée sur l'actionneur piézoélectrique 200 résultant de la déformation, cette deuxième fonction assurant ladite mesure simultanée de charge électrique.

En outre, la seconde fonction principale FP2 est assurée par des moyens d'acquisition des mesures de la variation de charge électrique, de traitement de ces acquisitions et d'estimation d'un déplacement de l'actionneur piézoélectrique 200 et/ou d'une force appliquée à partir de la mesure de la variation de charge électrique accumulée sur l'actionneur piézoélectrique.

La figure 2 montre un schéma d'un actionneur selon ce mode de réalisation, ici un piézotube. Sur cette figure sont visibles le matériau piézoélectrique 201 formant tube, l'électrode de masse $E_m$ disposée sur la paroi interne 202 du tube et les électrodes $E_1$, $E_2$, $E_3$, $E_4$ de potentiels actifs disposées sur différents secteurs de la paroi externe 203 du tube (seules trois des quatre électrodes de potentiels actifs sont ici représentées)

Ainsi dans cette figure $V_1$, $V_2$, $V_3$ et $V_4$ désignent les potentiels électriques appliqués respectivement aux électrodes de potentiels actifs $E_1$, $E_2$, $E_3$, $E_4$.

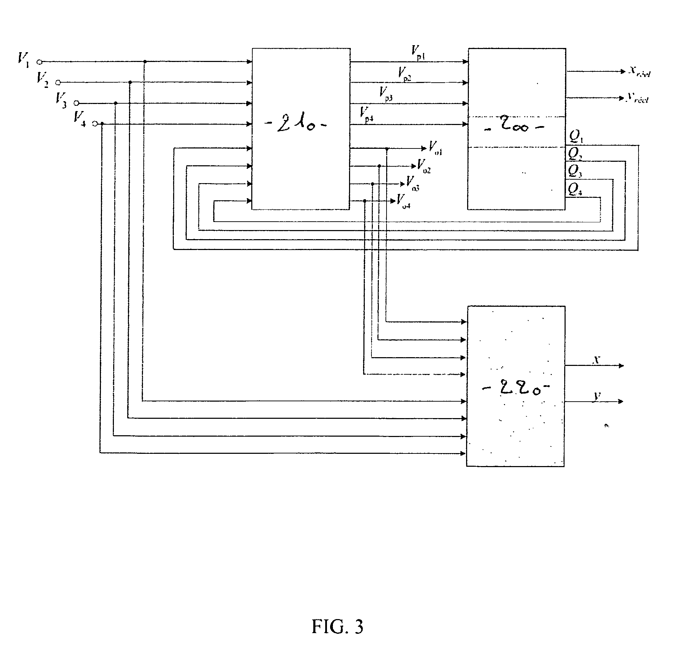

La figure 3 montre un schéma structurel général d'un dispositif de micropositionnement d'un actionneur piézoélectrique selon ce même mode de réalisation.

Sont plus précisément représentés dans ce schéma électrique du dispositif de micropositionnement :

- un circuit électrique 210 permettant de transformer les variations de charges $Q_i$ mesurées sur l'électrode de potentiel actif Ei en tension exploitable $V_{oi}$ ;

- un observateur 220, ou estimateur, permettant de fournir les valeurs x et y qui sont les valeurs estimées des déplacements réels $x_{rel}$ et $y_{rel}$ à l'extrémité de l'actionneur, à partir des signaux disponibles que sont les tensions exploitables $V_{oi}$ et les tensions de commande $V_i$ ; et

- un actionneur piézoélectrique 200 ;

où i est ici un entier compris entre 1 et 4, i étant utilisé pour se référer à une électrode $E_i$.

Pour simplifier les schémas ici illustrés, le calcul de la valeur estimée du déplacement z n'est ici pas développé mais est bien entendu estimé de manière semblable aux déplacements x et y.

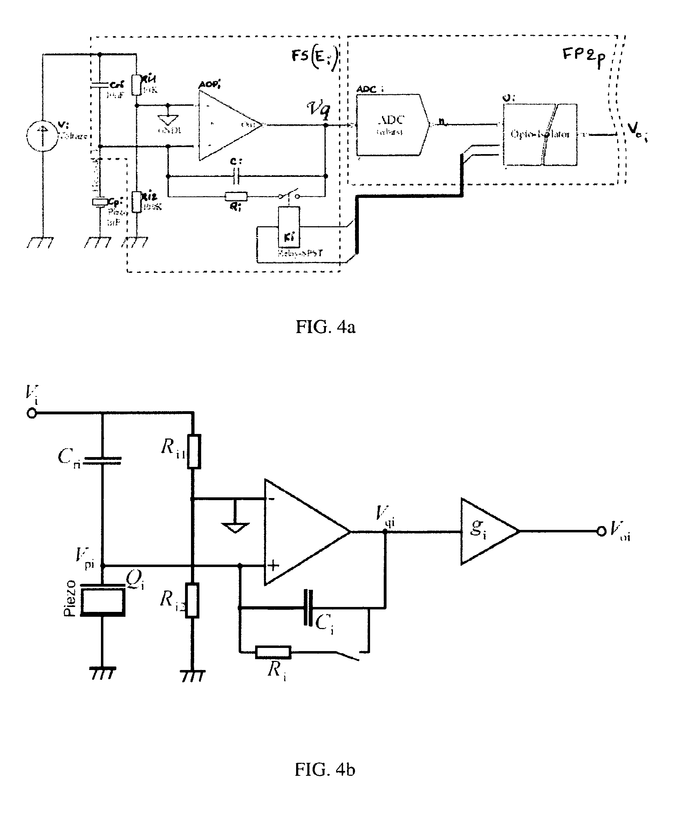

Les figures 4a et 4b montrent des schémas d'un circuit électrique associé à une électrode selon ce mode de réalisation.

Plus précisément, est représenté figure 4a un circuit électrique d'une électrode $E_i$ permettant d'assurer à la fois la première fonction secondaire FS1i et la deuxième fonction secondaire FS2i, ces deux fonctions secondaires étant regroupées en une fonction secondaire associée à une électrode $E_i$ et notée $FS(E_i)$.

Un circuit électrique partiel est illustré assurant partiellement la fonction principale FP2, noté ici FP2p

Ainsi, la figure 4a détaille le schéma de principe d'une fonction secondaire $FS(E_i)$ associée à une électrode $E_i$, i étant un entier compris entre 1 et 4, valable pour un secteur du piézotube.

L'indice i représentant le numéro de la voie ne sera pas rappelé dans la suite de l'exposé, afin d'alléger les notations.

Chaque secteur du piézotube est repéré « Piezo » et est assimilé à une capacité Cp.

Une charge Q est appliquée sur chaque secteur de l'actionneur par l'intermédiaire de la tension V, via une capacité $C_r$. Cette dernière est choisie pour ses faibles pertes. Elle est alors considérée comme linéaire et stable.

Sa valeur est telle que la majeure partie de la tension d'entrée V se retrouve sur l'actionneur piézoélectrique. Un rapport de un dixième est satisfaisant mais tout autre ratio est possible.

La tension V alimente également un pont diviseur composé de $R_{i1}$ et $R_{i2}$ (i est de nouveau le numéro de voie de 1 à 4), noté par la suite $R_1$ et $R_2$, assurant l'équilibre entre les deux branches du pont si $\dfrac{R_1}{R_2} = \dfrac{C_p}{C_r}$.

Toutes modifications de la capacité $C_p$, résultant des déformations de chaque secteur, modifient l'équilibre des charges qui seront alors mesurées par l'amplificateur de charges composé par le circuit de l'amplificateur opérationnel, noté AOP, et la capacité C.

La résistance R et l'interrupteur K, permettent la remise à zéro complète des charges présentes sur les armatures du condensateur de mesure C.

Le schéma de la figure 4a peut être assimilé au schéma de la figure 4B où $g_i$ est un gain à identifier. Ce gain inclue un gain dans un opto-coupleur, un gain dans un convertisseur analogique - numérique et éventuellement un gain d'ajustement dans un circuit intégrateur.

Plus précisément, les différents signaux et variables de la figure 4b sont listés ci-après :

- $V_i$ est le potentiel de commande,

- $V_{pi}$ est le potentiel retrouvé sur l'électrode $E_i$,

- $V_{qi}$ est le potentiel à la sortie de l'amplificateur opérationnel $AOP_i$,

- $V_{oi}$ est le potentiel exploitable retrouvé à la sortie du circuit électrique,

- $Q_i$ indique les charges apparaissant sur l'électrode $E_i$,

- $C_{ri}$ est une capacitance pour un pont diviseur,

- $C_{pi}$ est une capacitance statique équivalente de l'actionneur piézoélectrique dans sa partie électrode $E_i$,

- Ci est une capacitance de mesure de variation des charges,

- $R_{i1}$ et $R_{i2}$ sont deux résistances pour le pont diviseur à l'entrée de l'amplificateur opérationnel $AOP_i$,

- Ri est une résistance de décharge,

- gi est le gain.

Dans ce mode de réalisation, le fonctionnement du dispositif de micropositionnement de l'actionneur piézoélectrique est régi par des équations électriques et des équations piézoélectriques. Ces équations sont ensuite utilisées pour dériver l'observateur, ou l'estimateur.

Nous rappelons que, dans la figure 4b illustrant le schéma électrique pour l'électrode i, $V_{pi}$ est la tension aux bornes de l'actionneur, partie électrode i, Vci est la tension aux bornes du condensateur Ci, $i_i$ est le courant qui traverse le condensateur $C_{ri}$, ici est le courant qui traverse le condensateur Ci et $i_{pzti}$ est le courant qui traverse l'actionneur par l'électrode i.

Les équations électriques sont alors plus précisément :

- les équations des tensions d'entrée ;

- l'équation de la tension $V_{ci}$ ; et

- l'équation de la tension de sortie exploitable $V_{oi}$.

Plus précisément, les équations des tensions d'entrée sont définies par les relations entre tensions à l'entrée de l'amplificateur opérationnel, incluant le diviseur résistif, lesquelles sont les suivantes :

$$\begin{cases} V_{pi} = V_+ \\ V_+ = V_- \\ V_- = \dfrac{R_{i2}}{(R_{i1} + R_{i2})} V_i \end{cases}$$

[1]

Où $V_+$ et $V_-$ sont les tensions à l'entrée de l'amplificateur opérationnel.

Par ailleurs, l'équation de la tension $V_{ci}$, est liée à la charge $Q_{ci}$ sur le condensateur $C_i$ par la relation suivante :

$$V_{ci} = \frac{1}{C_i} Q_{ci} = \frac{1}{C_i} \int_0^t i_{ci} dt$$

[2]

Or:

$$i_{ci} = i_i - i_{pzti} - i_{biasi}$$

[3]

où $i_{biasi}$ est le courant de fuite dans l'amplificateur opérationnel.

Par ailleurs, le courant dans la relation liant le courant $i_{pzt}$ dans l'actionneur et les charges sur celui-ci est :

$$\int_0^t i_{pzti} dt = Q_{defi} + G_{DAi} + \int_0^t i_{leaki} dt$$

[4]

où $Q_{defi}$ est la charge générée par l'application de la tension $V_{pi}$ et par la déformation de l'actionneur, $Q_{DAi}$ est la charge dûe à l'absorption diélectrique du matériau (201) et $i_{leaki}$ est le courant de fuite. Ces grandeurs peuvent avoir des gains positifs ou négatifs. Le courant de fuite $i_{leaki}$ est lié à la résistance de fuite $R_{fpi}$ dans l'actionneur comme suit :

$$i_{leaki} = \frac{V_{pi}}{R_{fpi}}$$

[5]

En utilisant les équations 2, 3, 4 et 5, il est possible d'en déduire la tension $V_{ci}$ :

$$V_{ci} = \frac{1}{C_i} \left( \int_0^t i_i dt - Q_{defi} - Q_{DAi} - \int_0^t \frac{V_{pi}}{R_{fpi}} dt - \int_0^t i_{biasi} dt \right)$$

[6]

or, d'après la figure 4a, les courant $i_i$ sont les suivants :

$$i_i = C_{ri} \frac{d(V_i - V_{pi})}{dt} \quad \Leftrightarrow \quad \int_0^t i_i dt = C_{ri}(V_i - V_{pi})$$

[7]

et, d'après l'équation 1, la tension $V_{pi}$ est :

$$V_{pi} = \frac{R_{i2}}{(R_{i1} + R_{i2})} V_i$$

[8]

qui, en utilisant les équations 7 et 8, mène à :

$$\int_0^t i_i dt = \frac{C_{ri} R_{i1}}{(R_{i1} + R_{i2})} V_i$$

[9]

En utilisant les équations 6, 8 et 9, il est possible de déduire l'équation finale de la tension $V_{ci}$ :

$$V_{ci} = \frac{1}{C_i} \left( \frac{C_{ri} R_{i1}}{(R_{i1} + R_{i2})} V_i - Q_{defi} - Q_{DAi} - \frac{R_{i2}}{R_{fpi}(R_{i1} + R_{i2})} \int_0^t V_i dt - \int_0^t i_{biasi} dt \right)$$

[10]

En outre, l'équation de la tension de sortie exploitable $V_{oi}$ peut être déduite à partir des équations liant les tensions $V_{oi}$, $V_{ci}$ et $V_{pi}$ qui sont les suivantes :

$$\begin{cases} \dfrac{V_{oi}}{g_i} = V_{qi} \\ V_{qi} + V_{ci} - V_+ = 0 \end{cases} \Rightarrow V_{oi} = g_i(V_+ - V_{ci})$$

[11]

En utilisant les équations 1 et 11, la tension $V_{oi}$ peut être définie comme suit :

$$V_{oi} = g_i \left( \frac{R_{i2}}{(R_{i1} + R_{i2})} V_i - V_{ci} \right)$$

[12]

En combinant les équations 10 et 12, il est obtenu l'équation de la tension exploitable $V_{oi}$ suivante :

$$V_{oi} = g_i \left[ \frac{R_{i2}}{(R_{i1} + R_{i2})} V_i - \frac{1}{C_i} \left( \frac{C_{ri} R_{i1}}{(R_{i1} + R_{i2})} V_i - Q_{defi} - Q_{DAi} - \frac{R_{i2}}{R_{fpi}(R_{i1} + R_{i2})} \int_0^t V_i dt - \int_0^t i_{biasi} dt \right) \right]$$

[13]

En ce qui concerne les équations piézoélectriques, celles-ci sont plus précisément les équations permettant de calculer les charges sur les électrodes.

La relation qui lie la déflection x à l'extrémité de l'actionneur piézoélectrique, ici de type piézotube, et les tensions $V_1$ et $V_3$ appliquées respectivement aux électrodes 1 et 3 est donnée par l'équation suivante :

$$x = aV_1 - aV_3 \iff (V_1 - V_3) = \frac{x}{a}$$

[14]

où a est le coefficient piézoélectrique pour une commande unipolaire, c'est-à-dire $U_1$ n'est pas forcément égale à -$U_3$. Ce coefficient est disponible dans de nombreux articles tel que dans l'article "Introduction to Scanning Tunneling Microscopy" rédigé par C.J. Chen et publié dans la revue Oxford University Press en 1993. La même relation est obtenue pour l'axe y :

$$y = aV_2 - aV_4 \quad \Leftrightarrow \quad (V_2 - V_4) = \frac{y}{a} \qquad [15]$$

Par ailleurs, en assumant les charges $Q_{def1}$ et $Q_{def3}$ :

- sur les électrodes identiques ($\square_1 = \square_3 = \square$) et antagonistes 1 et 3 pour l'axe x ; et

- sur les électrodes identiques ($\beta_2 = \beta_4 = \beta$) et antagonistes 2 et 4 pour l'axe y ;

écrites de façons paramétriques par rapport aux tensions $U_i$ (i étant ici un nombre entier compris entre 1 et 4), en tenant compte de la symétrie de l'actionneur, nous obtenons :

$$\begin{cases} Q_{def1} = \alpha V_1 - \alpha V_3 + \beta V_2 - \beta V_4 = \alpha(V_1 - V_3) + \beta(V_2 - V_4) \\ Q_{def3} = -\alpha V_1 + \alpha V_3 + \beta V_2 - \beta V_4 = -\alpha(V_1 - V_3) + \beta(V_2 - V_4) \end{cases} \qquad [16]$$

La même équation peut être écrite pour les charges $Q_{def2}$ et $Q_{def4}$ pour l'axe y :

$$\begin{cases} Q_{def2} = \alpha V_2 - \alpha V_4 + \beta V_1 - \beta V_3 = \alpha(V_2 - V_4) + \beta(V_1 - V_3) \\ Q_{def4} = -\alpha V_2 + \alpha V_4 + \beta V_1 - \beta V_3 = -\alpha(V_2 - V_4) + \beta(V_1 - V_3) \end{cases} \qquad [17]$$

En introduisant les équations 14 et 15 dans les équations 16 et 17, nous obtenons les équations des charges sur les électrodes :

$$\begin{cases} \begin{cases} Q_{def1} = \alpha\dfrac{x}{a} + \beta\dfrac{y}{a} \\ Q_{def3} = -\alpha\dfrac{x}{a} + \beta\dfrac{y}{a} \end{cases} \\ \\ \begin{cases} Q_{def2} = \alpha\dfrac{y}{a} + \beta\dfrac{x}{a} \\ Q_{def4} = -\alpha\dfrac{y}{a} + \beta\dfrac{x}{a} \end{cases} \end{cases} \qquad [18]$$

En combinant les équations électriques et piézoélectriques, c'est-à-dire en introduisant les équations des charges sur les électrodes (équation 18) dans l'équation de la tension exploitable de $V_{oi}$ (équation 13), nous obtenons :

$$\frac{V_{o1}}{g_1} = \frac{R_{12}}{(R_{11}+R_{12})}V_1 - \frac{C_{r1}R_{11}}{C_1(R_{11}+R_{12})}V_1 + \frac{1}{C_1}\left(\alpha\frac{x}{a} + \beta\frac{y}{a} + Q_{DA1} + \frac{R_{12}}{R_{fp1}(R_{11}+R_{12})}\int_0^t V_1 dt + \int_0^t i_{bias1} dt\right)$$

$$\frac{V_{o3}}{g_3} = \frac{R_{32}}{(R_{31}+R_{32})}V_3 - \frac{C_{r3}R_{31}}{C_3(R_{31}+R_{32})}V_3 + \frac{1}{C_3}\left(-\alpha\frac{x}{a} + \beta\frac{y}{a} + Q_{DA3} + \frac{R_{32}}{R_{fp3}(R_{31}+R_{32})}\int_0^t V_3 dt + \int_0^t i_{bias3} dt\right)$$

$$\frac{V_{o2}}{g_2} = \frac{R_{22}}{(R_{21}+R_{22})}V_2 - \frac{C_{r2}R_{21}}{C_2(R_{21}+R_{22})}V_2 + \frac{1}{C_2}\left(\alpha\frac{y}{a} + \beta\frac{x}{a} + Q_{DA2} + \frac{R_{22}}{R_{fp2}(R_{21}+R_{22})}\int_0^t V_2 dt + \int_0^t i_{bias2} dt\right)$$

$$\frac{V_{o4}}{g_4} = \frac{R_{42}}{(R_{41}+R_{42})}V_4 - \frac{C_{r4}R_{41}}{C_4(R_{41}+R_{42})}V_4 + \frac{1}{C_4}\left(-\alpha\frac{y}{a} + \beta\frac{x}{a} + Q_{DA4} + \frac{R_{42}}{R_{fp4}(R_{41}+R_{42})}\int_0^t V_4 dt + \int_0^t i_{bias4} dt\right)$$

[19]

En supposant les équations suivantes :

$$\begin{cases} C_1 = C_2 = C_3 = C_4 = C \\ g_1 = g_2 = g_3 = g_4 = g \\ \gamma_i = \frac{R_{i2}}{(R_{i1}+R_{i2})} - \frac{C_{ri}R_{i1}}{C_i(R_{i1}+R_{i2})} \\ \lambda_i = \frac{R_{i2}}{R_{fpi}(R_{i1}+R_{i2})} \end{cases}$$

[20]

nous obtenons les équations données ci-après :

$$\frac{V_{o1}}{g} = \gamma_1 V_1 + \frac{1}{C}\left(\alpha\frac{x}{a} + \beta\frac{y}{a} + Q_{DA1} + \lambda_1\int_0^t V_1 dt + \int_0^t i_{bias1} dt\right)$$

$$\frac{V_{o3}}{g} = \gamma_3 V_3 + \frac{1}{C}\left(-\alpha\frac{x}{a} + \beta\frac{y}{a} + Q_{DA3} + \lambda_3\int_0^t V_3 dt + \int_0^t i_{bias3} dt\right)$$

$$\frac{V_{o2}}{g} = \gamma_2 V_2 + \frac{1}{C}\left(\alpha\frac{y}{a} + \beta\frac{x}{a} + Q_{DA2} + \lambda_2\int_0^t V_2 dt + \int_0^t i_{bias2} dt\right)$$

$$\frac{V_{o4}}{g} = \gamma_4 V_4 + \frac{1}{C}\left(-\alpha\frac{y}{a} + \beta\frac{x}{a} + Q_{DA4} + \lambda_4\int_0^t V_4 dt + \int_0^t i_{bias4} dt\right)$$

[21]

Enfin, à partir de l'équation 21 il est possible de calculer les soustractions ($V_{o1} - V_{o3}$) et ($V_{o2} - V_{o4}$) comme suit :

$$\begin{cases} V_{o1} - V_{o3} = g(\gamma_1 V_1 - \gamma_3 V_3) + \frac{2g\alpha}{aC}x + \frac{g}{C}(Q_{DA1} - Q_{DA3}) + \frac{g}{C}\int_0^t (i_{bias1} - i_{bias3})dt + \frac{g}{C}\int_0^t (\lambda_1 V_1 - \lambda_3 V_3)dt \\ \\ V_{o2} - V_{o4} = g(\gamma_2 V_2 - \gamma_4 V_4) + \frac{2g\alpha}{aC}y + \frac{g}{C}(Q_{DA2} - Q_{DA4}) + \frac{g}{C}\int_0^t (i_{bias2} - i_{bias4})dt + \frac{g}{C}\int_0^t (\lambda_2 V_2 - \lambda_4 V_4)dt \end{cases}$$

[22]

Il a été admis par ailleurs que la charge due à l'absorption diélectrique $Q_{DAi}(t)$ est approximable par un système du premier ordre. En Laplace, cela donne :

$$Q_{DAi}(s) = \frac{k_{DAi}}{(1 + \tau_{DAi}s)} V_i(s) = Q_{tfDAi}(s)V_i(s)$$

[23]

où s est la variable de Laplace, $k_{DAi}$ est le gain statique (pouvant être positif ou négatif dans notre cas) et $\tau_{DAi}$ est la constante de temps. $Q_{tfDAi}(s)$ est la fonction de transfert qui lie la charge $Q_{DAi}(s)$ et la tension d'entrée $V_i(s)$.

Par conséquent, grâce à l'ensemble de ces équations, il est ainsi possible de déduire les équations de l'observateur, ou estimateur. Notamment, à partir de l'équation 22, les déplacements x et y sont régies par les équations suivantes :

$$\begin{cases} x = \frac{a}{2\alpha} \left[ \frac{C}{g}(V_{o1} - V_{o3}) - C(\gamma_1 V_1 - \gamma_3 V_3) - (Q_{DA1} - Q_{DA3}) - \int_0^t (i_{bias1} - i_{bias3})\,dt - \int_0^t (\lambda_1 V_1 - \lambda_3 V_3)\,dt \right] \\[4mm] y = \frac{a}{2\alpha} \left[ \frac{C}{g}(V_{o2} - V_{o4}) - C(\gamma_2 V_2 - \gamma_4 V_4) - (Q_{DA2} - Q_{DA4}) - \int_0^t (i_{bias2} - i_{bias4})\,dt - \int_0^t (\lambda_2 V_2 - \lambda_4 V_4)\,dt \right] \end{cases}$$

[24]

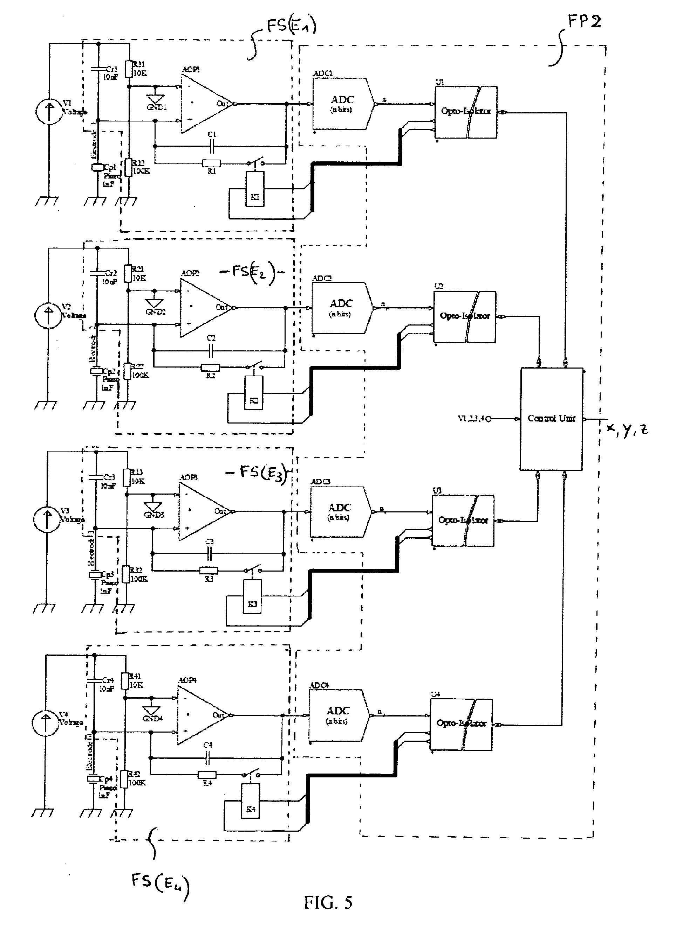

La figure 5 montre un schéma d'un circuit électrique d'ensemble associé à un actionneur piézoélectrique de type piézotube selon ce mode de réalisation.

En effet, est représenté sur cette figure quatre schémas de principe des fonctions secondaires $FS(E_1)$, $FS(E_2)$, $FS(E_3)$, $FS(E_4)$ tels qu'illustrés figure 4a, chacun associé respectivement à l'électrode $E_1$, $E_2$, $E_3$, $E_4$ de potentiels actifs disposées sur différents secteurs de la paroi externe 203 du matériau piézoélectrique 201 formant tube.

Par ailleurs, chacun de ces circuits électrique assurant lesdites des fonctions secondaires $FS(E_1)$, $FS(E_2)$, $FS(E_3)$, $FS(E_4)$ est relié en série à un autre circuit électrique assurant quant à lui, associé avec une unité de contrôle, la seconde fonction principale FP2, assurant notamment l'acquisition, le traitement et l'estimation des déplacements x, y, les valeurs x et y étant les valeurs estimées des déplacements réels $x_{rel}$ et $y_{rel}$.

Pour simplifier les schémas ici illustrés, le calcul de la valeur estimée du déplacement z n'est ici pas développé mais est bien entendu estimé de manière semblable.

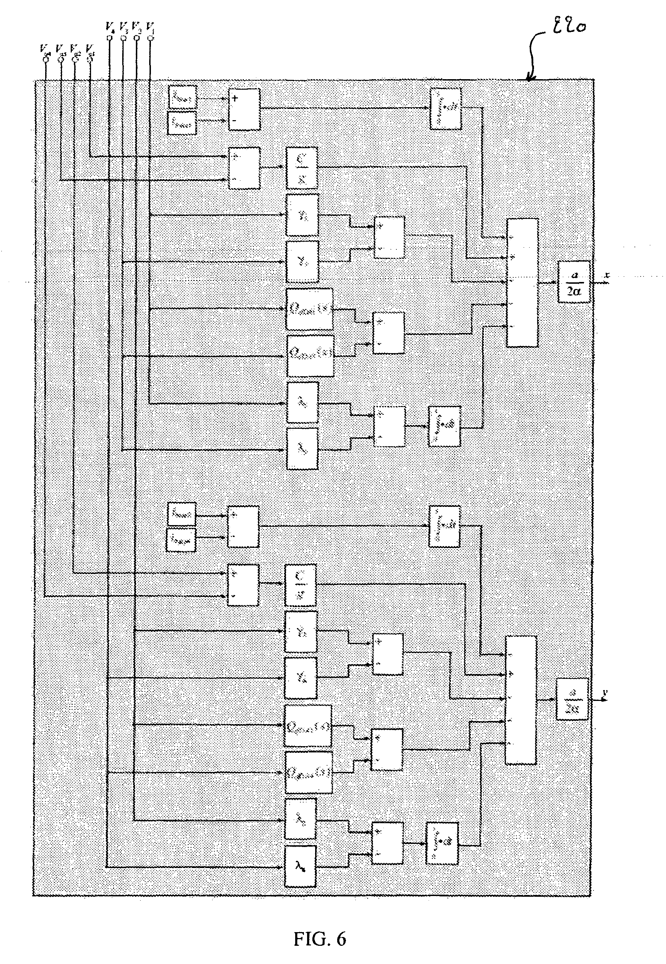

La figure 6 montre un schéma bloc détaillé d'un observateur, ou estimateur, selon ce mode de réalisation et par lequel les opérations mathématiques effectuées décrites ci-avant permettent en de mesurer en sortie les déplacements x et y sont régies par l'équation 24.

**Revendications**

1. Dispositif de micropositionnement (100) d'un actionneur piézoélectrique (200), ledit actionneur piézoélectrique (200) comprenant au moins un matériau piézoélectrique (201) apte à se déformer lorsqu'il est soumis à un champ électrique, le dispositif comprenant :

   - des moyens de commande d'un champ électrique appliqué audit actionneur piézoélectrique (200) de sorte à déformer le matériau piézoélectrique (201) et,
   - des moyens de mesure simultanée d'une variation de charge électrique accumulée sur l'actionneur piézoélectrique (200) résultant de la déformation; et
   - des moyens d'acquisition des mesures de la variation de charge électrique, de traitement de ces acquisitions et d'estimation d'un déplacement (x, y, z) de l'actionneur piézoélectrique (200) et/ou d'une force appliquée à partir de la mesure de la variation de charge électrique accumulée sur l'actionneur piézoélectrique (200)

   le dispositif étant **caractérisé en ce que** les moyens de commande et de mesure comprennent en outre :

   - un générateur de tension connecté en parallèle à :

     • un pont diviseur, le pont diviseur étant composé d'une première résistance et d'une seconde résistance en série, et à
     • une première capacité connectée en série à l'actionneur piézo-électrique,

   - un amplificateur de charges ayant une première entrée connectée à un noeud entre les deux résistances formant une masse virtuelle à haut potentiel flottant et une seconde entrée connectée à un noeud entre la première capacité et l'actionneur piézo-électrique.

2. Dispositif de micropositionnement selon la revendication 1, **caractérisé en ce que** l'actionneur piézoélectrique (200) comprend au moins trois électrodes ($E_m$, $E_1$, $E_2$, $E_3$, $E_4$) dont au moins une électrode de masse ($E_m$) et au mois deux électrodes de potentiels actifs ($E_1$, $E_2$, $E_3$, $E_4$).

3. Dispositif de micropositionnement selon la revendication 2, **caractérisé en ce que** l'actionneur piézoélectrique (200) est un piezotube comprenant le matériau piézoélectrique (201) formant tube, l'électrode de masse ($E_m$) disposée sur une paroi interne (202) du tube et au moins deux électrodes de potentiels actifs ($E_1$, $E_2$, $E_3$, $E_4$) disposées sur une paroi externe (203) du tube.

4. Dispositif de micropositionnement selon l'une des revendications précédentes, **caractérisé en ce que** les moyens (101) de commande du champ électrique et, des moyens (102) de mesure simultanée de la variation de la charge électrique comportent au moins un circuit de commande du champ électrique appliqué audit actionneur piézoélectrique et de mesure de la variation de charge accumulée sur les électrodes de potentiels actifs ($E_1$, $E_2$, $E_3$, $E_4$).

5. Dispositif de micropositionnement selon l'une quelconque des revendications précédentes, **caractérisé en ce que** l'amplificateur de charges comprend un amplificateur opérationnel et une seconde capacité connectée entre la seconde entrée et la sortie de l'amplificateur opérationnel.

6. Dispositif de micropositionnement selon la revendication 5, **caractérisé en ce que** les moyens de commande et de mesure comprennent en outre un circuit de remise à zéro des charges présentes sur la seconde capacité.

7. Dispositif de micropositionnement selon l'une quelconque des revendications précédentes, **caractérisé en ce que** le dispositif piézo-électrique étant assimilable au repos à une capacité, la première capacité et les première et seconde résistances sont choisies de sorte que le ratio entre la première et la seconde résistance est sensiblement égal au ratio entre la première capacité et la capacité du dispositif piézo-électrique au repos.

8. Dispositif de micropositionnement selon l'une quelconque des revendications précédentes, **caractérisé en ce que** la première capacité est sélectionnée pour avoir une résistance de fuite supérieure à 100 GOhm.

9. Dispositif de micropositionnement selon l'une quelconque des revendications précédentes, **caractérisé en ce que** la première capacité est sélectionnée de sorte à ce que au moins 50% de la tension délivrée par le générateur de tension se retrouve sur le dispositif piézoélectrique et, de préférence, au moins 90%.

10. Dispositif de micropositionnement selon l'une quelconque des revendications précédentes, **caractérisé en ce que** la sortie de chaque amplificateur de charges est connectée à un convertisseur analogique - numérique connecté à un calculateur via des circuits d'isolation galvanique ; le calculateur estimant le déplacement de l'actionneur et/ou la déformation du matériaux et/ou la force appliquée à partir de la variation de charges reçue des l'amplificateurs de charges et des tensions appliquées par les générateurs de tension.

11. Dispositif de micropositionnement selon l'une quelconque des revendications précédentes, **caractérisé en ce que** le dispositif piézo-électrique comporte au moins trois électrodes dont au moins une électrode de masse et au mois deux électrodes de potentiels actifs, le dispositif comprenant autant de moyens de commande et de mesure que d'électrodes actives, connectés un à un, et les moyens de commande et de mesure étant connectés à un unique calculateur adapté pour déplacer et mesurer le dispositif piézo-électrique dans au moins deux dimensions.

12. Procédé de micropositionnement d'au moins un actionneur piézoélectrique (200) mis en oeuvre par un dispositif selon l'une quelconque des revendications 1 à 11, **caractérisé en ce qu'**il comprend les étapes suivantes :

- des étapes:

• de commande, par les moyens de commande, de l'actionneur piézoélectrique par application d'un champ électrique audit actionneur piézoélectrique de sorte à déformer le matériau piézoélectrique ; et
• de mesure simultanée, par des moyens de mesure simultanée, d'une variation de charge électrique accumulée sur l'actionneur piézoélectrique résultant de la déformation ;

- au moins une étape d'acquisition des mesures de la variation de charge électrique, de traitement de ces acquisitions et d'estimation d'un déplacement (x, y, z) de l'actionneur piézoélectrique (200) et/ou d'une force appliquée à partir de ladite mesure de la variation de charge électrique accumulée sur l'actionneur piézoélectrique (200).

**Patentansprüche**

1. Vorrichtung zur Mikropositionierung (100) eines piezoelektrischen Aktuators (200), wobei der piezoelektrische Aktuator (200) mindestens ein piezoelektrisches Material (201) umfasst, das ausgelegt ist, um sich zu verformen, wenn es einem elektrischen Feld ausgesetzt wird, wobei die Vorrichtung Folgendes umfasst:

   - Mittel zum Steuern eines elektrischen Felds, das auf den piezoelektrischen Aktuator (200) angelegt ist, um das piezoelektrische Material (201) zu verformen, und
   - Mittel zum gleichzeitigen Messen einer Variation der auf dem piezoelektrischen Aktuator (200) angesammelten elektrischen Ladung, die sich aus der Verformung ergibt; und
   - Mittel zum Erfassen von Messungen der Variation der elektrischen Ladung, zur Verarbeitung dieser Erfassungen und zum Schätzen einer Verschiebung (x, y, z) des piezoelektrischen Aktuators (200) und/oder einer Kraft, die auf der Grundlage der Messung der Variation der elektrischen Ladung, die auf dem piezoelektrischen Aktuator (200) angesammelt ist, angewendet wird,

   wobei die Vorrichtung **dadurch gekennzeichnet ist, dass** die Mittel zum Steuern und Messen außerdem Folgendes umfassen:

   - einen Spannungsgenerator, der parallel verbunden ist mit:

      • eine Teilerbrücke, wobei die Teilerbrücke aus einem ersten Widerstand und einem zweiten Widerstand in Reihe zusammengesetzt ist,
      • einer ersten Kapazität, die in Reihe mit dem piezoelektrischen Aktuator verbunden ist,

   - einen Ladungsverstärker mit einem ersten Eingang, der mit einem Knoten zwischen den zwei Widerständen verbunden ist, der eine virtuelle Masse mit hohem Schwebepotenzial bildet, und einem zweiten Eingang, der mit einem Knoten zwischen der ersten Kapazität und dem piezoelektrischen Aktuator verbunden ist.

2. Vorrichtung zur Mikropositionierung nach Anspruch 1, **dadurch gekennzeichnet, dass** der piezoelektrische Aktuator (200) mindestens drei Elektroden ($E_m$, $E_1$, $E_2$, $E_3$, $E_4$) umfasst, davon mindestens eine Masseelektrode ($E_m$) und mindestens zwei Elektroden mit aktiven Potenzialen ($E_1$, $E_2$, $E_3$, $E_4$).

3. Vorrichtung zur Mikropositionierung nach Anspruch 2, **dadurch gekennzeichnet, dass** der piezoelektrische Aktuator (200) ein piezoelektrisches Rohr ist, umfassend das piezoelektrische Material (201), das das Rohr bildet, die Masseelektrode ($E_m$), die auf einer inneren Wand (202) des Rohrs angebracht ist, und mindestens zwei Elektroden mit aktiven Potenzialen ($E_1$, $E_2$, $E_3$, $E_4$), die auf einer äußeren Wand (203) des Rohrs angebracht sind.

4. Vorrichtung zur Mikropositionierung nach einem der vorhergehenden Ansprüche, **dadurch gekennzeichnet, dass** die Mittel (101) zum Steuern des elektrischen Felds und Mittel (102) zum gleichzeitigen Messen einer Variation der elektrischen Ladung mindestens eine Schaltung zur Steuerung des elektrischen Felds umfassen, das auf den piezoelektrischen Aktuator angelegt ist, und zur Messung der Variation der Ladung, die auf den Elektroden mit aktiven Potenzialen ($E_1$, $E_2$, $E_3$, $E_4$) angesammelt ist.

5. Vorrichtung zur Mikropositionierung nach einem der vorhergehenden Ansprüche, **dadurch gekennzeichnet, dass** der Ladungsverstärker einen Operationsverstärker umfasst und eine zweite Kapazität, die zwischen dem zweiten Eingang und dem Ausgang des Operationsverstärkers verbunden ist.

6. Vorrichtung zur Mikropositionierung nach Anspruch 5, **dadurch gekennzeichnet, dass** die Mittel zum Steuern und zum Messen außerdem eine Schaltung zur Rückstellung auf null der Ladungen umfassen, die auf der zweiten Kapazität vorhanden sind.

**7.** Vorrichtung zur Mikropositionierung nach einem der vorhergehenden Ansprüche, **dadurch gekennzeichnet, dass**, da die piezoelektrische Vorrichtung in der Ruhestellung mit einer Kapazität gleichsetzbar ist, die erste Kapazität und der erste und der zweite Widerstand derart ausgewählt sind, dass das Verhältnis zwischen dem ersten und dem zweiten Widerstand im Wesentlichen gleich dem Verhältnis zwischen der ersten Kapazität und der Kapazität der piezoelektrischen Vorrichtung in der Ruhestellung ist.

**8.** Vorrichtung zur Mikropositionierung nach einem der vorhergehenden Ansprüche, **dadurch gekennzeichnet, dass** die erste Kapazität ausgewählt ist, um einen Ableitwiderstand von mehr als 100 GOhm aufzuweisen.

**9.** Vorrichtung zur Mikropositionierung nach einem der vorhergehenden Ansprüche, **dadurch gekennzeichnet, dass** die erste Kapazität derart ausgewählt ist, dass sich mindestens 50 % der Spannung, die vom Spannungsgenerator geliefert wird, auf der piezoelektrischen Vorrichtung wieder findet, und vorzugsweise mindestens 90 %.

**10.** Vorrichtung zur Mikropositionierung nach einem der vorhergehenden Ansprüche, **dadurch gekennzeichnet, dass** der Ausgang jedes Ladungsverstärkers mit einem Analog-Digital-Wandler verbunden ist, der über Schaltungen mit galvanischer Isolation mit einem Rechner verbunden ist; wobei der Rechner die Verschiebung des Aktuators und/oder die Verformung der Materialien und/oder die Kraft schätzt, die auf Grundlage der Variation der Ladungen angewendet wird, die von den Ladungsverstärkern und den Spannungen erhalten wird, die von den Spannungsgeneratoren angelegt werden.

**11.** Vorrichtung zur Mikropositionierung nach einem der vorhergehenden Ansprüche, **dadurch gekennzeichnet, dass** die piezoelektrische Vorrichtung mindestens drei Elektroden umfasst, davon mindestens eine Masseelektrode und mindestens zwei Elektroden mit aktiven Potenzialen, wobei die Vorrichtung ebenso viele Mittel zum Steuern und zum Messen wie aktive Elektroden umfasst, die miteinander verbunden sind, und die Mittel zum Steuern und zum Messen mit einem einzigen Rechner verbunden sind, der ausgelegt ist, um die piezoelektrische Vorrichtung in mindestens zwei Dimensionen zu verschieben und zu messen.

**12.** Verfahren zur Mikropositionierung von mindestens einem piezoelektrischen Aktuator (200), ausgeführt durch eine Vorrichtung nach einem der Ansprüche 1 bis 11, **dadurch gekennzeichnet, dass** es die folgenden Schritte umfasst:

- Schritte

• des Steuerns, durch die Mittel zum Steuern des piezoelektrischen Aktuators durch das Anlegen eines elektrischen Felds auf den piezoelektrischen Aktuator, um das piezoelektrische Material zu verformen; und
• des gleichzeitigen Messens, durch Mittel zum gleichzeitigen Messen, einer Variation der auf dem piezoelektrischen Aktuator angesammelten elektrischen Ladung, die sich aus der Verformung ergibt;

- mindestens einen Schritt des Erfassens der Messungen der Variation der elektrischen Ladung, des Verarbeitens dieser Erfassungen und des Schätzens einer Verschiebung (x, y, z) des piezoelektrischen Aktuators (200) und/oder einer Kraft, die auf der Grundlage der Messung der Variation der elektrischen Ladung, die auf dem piezoelektrischen Aktuator (200) angesammelt ist, angewendet wird.

**Claims**

**1.** A micropositioning device (100) for a piezoelectric actuator (200), said piezoelectric actuator (200) comprising at least one piezoelectric material (201) capable of deforming when it is subjected to an electric field, the device comprising:

- means for controlling an electric field applied to said piezoelectric actuator (200) so as to deform the piezoelectric material (201), and
- means for simultaneously measuring a variation in electric charge accumulated on the piezoelectric actuator (200) as a result of the deformation; and
- means for acquiring measurements of the electric charge variation, for processing these acquisitions and for estimating a displacement (x, y, z) of the piezoelectric actuator (200) and/or an applied force on the basis of the measurement of the variation in electric charge accumulated on the piezoelectric actuator (200),

the device being **characterized in that** the means for controlling and the means for measuring further comprise:

- a voltage generator connected in parallel to:

• a divider bridge, the divider bridge being composed of a first resistor and a second resistor in series, and to
• a first capacitor connected in series with the piezoelectric actuator,

- a charge amplifier having a first input connected to a node between the two resistors, forming a virtual ground at floating high potential, and a second input connected to a node between the first capacitor and the piezoelectric actuator.

2. The micropositioning device as claimed in claim 1, **characterized in that** the piezoelectric actuator (200) comprises at least three electrodes ($E_m$, $E_1$, $E_2$, $E_3$, $E_4$), including at least one ground electrode ($E_m$) and at least two active potential electrodes ($E_1$, $E_2$, $E_3$, $E_4$).

3. The micropositioning device as claimed in claim 2, **characterized in that** the piezoelectric actuator (200) is a piezo tube comprising the piezoelectric material (201) forming the tube, the ground electrode ($E_m$) arranged on an internal wall (202) of the tube and at least two active potential electrodes ($E_1$, $E_2$, $E_3$, $E_4$) arranged on an external wall (203) of the tube.

4. The micropositioning device as claimed in one of the preceding claims, **characterized in that** the means (101) for controlling the electric field and the means (102) for simultaneously measuring the variation in the electric charge comprise at least one circuit for controlling the electric field applied to said piezoelectric actuator and for measuring the variation of charge accumulated on the active potential electrodes ($E_1$, $E_2$, $E_3$, $E_4$).

5. The micropositioning device as claimed in any one of the preceding claims, **characterized in that** the charge amplifier comprises an operational amplifier and a second capacitor connected between the second input and the output of the operational amplifier.

6. The micropositioning device as claimed in claim 5, **characterized in that** the control and measurement means furthermore comprise a circuit for resetting to zero the charges present on the second capacitor.

7. The micropositioning device as claimed in any one of the preceding claims, **characterized in that**, the piezoelectric device being likenable at rest to a capacitor, the first capacitor and the first and second resistors are selected so that the ratio between the first and the second resistor is substantially equal to the ratio between the first capacitor and the capacitor of the piezoelectric device at rest.

8. The micropositioning device as claimed in any one of the preceding claims, **characterized in that** the first capacitor is selected so as to have a leakage resistance of more than 100 Gohm.

9. The micropositioning device as claimed in any one of the preceding claims, **characterized in that** the first capacitor is selected so that at least 50%, and preferably at least 90%, of the voltage delivered by the voltage generator is found on the piezoelectric device.

10. The micropositioning device as claimed in any one of the preceding claims, **characterized in that** the output of each charge amplifier is connected to an analog-digital converter connected to a computer via galvanic isolation circuits; the computer estimating the displacement of the actuator and/or the deformation of the materials and/or the applied force on the basis of the charge variation received from the charge amplifiers and the voltages applied by the voltage generators.

11. The micropositioning device as claimed in any one of the preceding claims, **characterized in that** the piezoelectric device comprises at least three electrodes, including at least one ground electrode and at least two active potential electrodes, the device comprising as many control and measurement means as active electrodes, connected one by one, and the control and measurement means being connected to a single computer adapted to displace and measure the piezoelectric device in at least two dimensions.

12. A method for micropositioning at least one piezoelectric actuator (200), carried out by a device as claimed in any one of claims 1 to 11, **characterized in that** it comprises the following steps:

- steps:

• of controlling, by the control means, the piezoelectric actuator by applying an electric field to said piezoelectric actuator so as to deform the piezoelectric material; and

• of simultaneous measurement, by simultaneous measurement means, of a variation in electric charge accumulated on the piezoelectric actuator as a result of the deformation;

- at least one step of acquiring the measurements of the electric charge variation, of processing these acquisitions and of estimating a displacement (x, y, z) of the piezoelectric actuator (200) and/or of an applied force on the basis of said measurement of the variation in electric charge accumulated on the piezoelectric actuator (200).

EP 2 828 968 B1

FIG. 1

FIG. 2

17

FIG. 3

FIG. 4a

FIG. 4b

FIG. 5

FIG. 6

**EP 2 828 968 B1**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 6285115 B1
- US 4945235 A
- US 5675296 A
- EP 0375570 A